(19) Europäisches Patentamt
European Patent Office
Office européen des brevets

(11) **EP 3 651 217 A1**

(12) **EUROPEAN PATENT APPLICATION**
published in accordance with Art. 153(4) EPC

(43) Date of publication:
**13.05.2020 Bulletin 2020/20**

(51) Int Cl.:
***H01L 35/32*** (2006.01)   ***H01L 35/08*** (2006.01)
***H01L 35/34*** (2006.01)   ***H02N 11/00*** (2006.01)

(21) Application number: **18828546.4**

(22) Date of filing: **29.06.2018**

(86) International application number:
**PCT/JP2018/024828**

(87) International publication number:
**WO 2019/009202 (10.01.2019 Gazette 2019/02)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **05.07.2017 JP 2017132050**
**22.06.2018 JP 2018118764**

(71) Applicant: **Mitsubishi Materials Corporation**
**Chiyoda-ku**
**Tokyo 100-8117 (JP)**

(72) Inventors:
• **ARAI Koya**
**Saitama-shi**
**Saitama 330-8508 (JP)**

• **NISHIMOTO Shuji**
**Saitama-shi**
**Saitama 330-8508 (JP)**
• **KOMASAKI Masahito**
**Saitama-shi**
**Saitama 330-8508 (JP)**
• **NAGATOMO Yoshiyuki**
**Saitama-shi**
**Saitama 330-8508 (JP)**
• **KUROMITSU Yoshirou**
**Naka-shi**
**Ibaraki 311-0102 (JP)**

(74) Representative: **Hoffmann Eitle**
**Patent- und Rechtsanwälte PartmbB**
**Arabellastraße 30**
**81925 München (DE)**

(54) **THERMOELECTRIC CONVERSION MODULE AND METHOD FOR PRODUCING THERMOELECTRIC CONVERSION MODULE**

(57)   A thermoelectric conversion module 10 includes thermoelectric conversion elements 11, and a first insulating circuit board provided with a first insulating layer 21 and a first electrode part 25 formed on one surface of the first insulating layer 21 is disposed on one end side of the thermoelectric conversion elements 11. The first electrode part 25 includes a first aluminum layer 25a made of aluminum or an aluminum alloy, and a first sintered silver layer 25b which is formed on a surface of the first aluminum layer 25a on a side opposite to the first insulating layer 21 and is formed of a sintered body of silver. The first aluminum layer 25a has a thickness in a range of 50 $\mu$m or more and 2000 $\mu$m or less. The first sintered silver layer 25b has a thickness of 5 $\mu$m or more and a porosity of less than 10% at least in a region where the thermoelectric conversion element 11 is disposed.

FIG. 1

**Description**

TECHNICAL FIELD

This invention relates to a thermoelectric conversion module in which a thermoelectric conversion elements are electrically connected to each other, and a method for producing a thermoelectric conversion module.

Priority is claimed on Japanese Patent Application No. 2017-132050, filed on July 5, 2017, and Japanese Patent Application No. 2018-118764, filed on June 22, 2018, the contents of which are incorporated herein by reference.

BACKGROUND ART

The above-described thermoelectric conversion element is an electronic element that enables conversion between thermal energy and electric energy by the Seebeck effect or the Peltier effect.

The Seebeck effect is a phenomenon in which an electromotive force is generated when a temperature difference is generated between both ends of a thermoelectric conversion element, and thermal energy is converted into electric energy. The electromotive force generated by the Seebeck effect is determined by the characteristics of the thermoelectric conversion element. In recent years, thermoelectric power generation utilizing this effect has been actively developed.

The Peltier effect is a phenomenon in which a temperature difference is generated at both ends of a thermoelectric conversion element when an electrode or the like is formed at both ends of the thermoelectric conversion element and a potential difference is generated between the electrodes, and electric energy is converted into thermal energy. An element having this effect is particularly called a Peltier element, and is used for cooling and temperature control of precision instruments and small refrigerators.

As a thermoelectric conversion module using the above-described thermoelectric conversion element, for example, a structure in which n-type thermoelectric conversion elements and p-type thermoelectric conversion elements are alternately connected in series has been proposed.

Such a thermoelectric conversion module has a structure in which a heat transfer plate is disposed on each of one end side and the other end side of a thermoelectric conversion elements, and the thermoelectric conversion elements are connected in series by electrode parts disposed in the heat transfer plates. As the above-described heat transfer plate, an insulating circuit board provided with an insulating layer and the electrode part may be used.

Electric energy is generated by the Seebeck effect by generating a temperature difference between the heat transfer plate disposed on one end side of the thermoelectric conversion element and the heat transfer plate disposed on the other end side of the thermoelectric conversion element. Alternatively, by passing a current through the thermoelectric conversion element, a temperature difference can be generated between the heat transfer plate disposed on the one end side of the thermoelectric conversion element and the heat transfer plate disposed on the other end side of the thermoelectric conversion element by the Peltier effect.

In the thermoelectric conversion module described above, in order to improve the thermoelectric conversion efficiency, it is necessary to keep the electric resistance in the electrode part connected to the thermoelectric conversion element low.

For this reason, in the related art, a silver paste or the like particularly excellent in conductivity is used to bond a thermoelectric conversion element to an electrode part. Furthermore, the electrode part itself may be formed of a silver paste and bonded to the thermoelectric conversion element.

However, a sintered body of the silver paste has a relatively large number of pores, and the electric resistance cannot be kept sufficiently low. In addition, there is concern that the thermoelectric conversion element may be altered due to the gas present in the pores.

In order to reduce the pores by densifying the sintered body of the silver paste, liquid phase sintering achieved by performing heating to the melting point of silver (960°C) or higher is considered. However, under such high temperature conditions, there is concern that the thermoelectric conversion element may be deteriorated by heat at the time of bonding.

For example, PTL 1 proposes a method of bonding a thermoelectric conversion element by forming an electrode part using a silver braze having a melting point lower than that of silver.

PTL 2 proposes a method of forming a dense film by applying a glass solution to the entire outer peripheral surface of a bonding layer and drying the glass solution in air in order to suppress deterioration of a thermoelectric conversion element due to gas in pores.

Citation List

Patent Literature

[PTL 1] Japanese Unexamined Patent Application, First Publication No. 2013-197265
[PTL 2] Japanese Unexamined Patent Application, First Publication No. 2012-231025

DISCLOSURE OF INVENTION

Technical Problem

In the method described in PTL 1, although the silver braze having a melting point lower than that of silver is used, it is preferable that the melting point of the silver braze used is, for example, 750°C to 800°C so that the silver braze does not melt even at an operating temperature of the thermoelectric conversion module (refer to paragraph 0023 of PTL 1). In a case where the thermoelectric conversion element is bonded under such a relatively high temperature condition, there is concern that the characteristics of the thermoelectric conversion elements may be deteriorated due to heat at the time of bonding.

In addition, in the method described in PTL 2, since the pores are present inside the bonding layer, the electric resistance in the electrode part connected to the thermoelectric conversion element cannot be kept low, and the thermoelectric conversion efficiency of the thermoelectric conversion module cannot be improved.

This invention has been made in view of the above-described circumstances, and an object thereof is to provide a thermoelectric conversion module in which the electric resistance in an electrode part is low, deterioration of a thermoelectric conversion element at the time of bonding is suppressed, and excellent thermoelectric conversion efficiency is achieved, and a method for producing a thermoelectric conversion module.

Solution to Problem

In order to solve the above problems, a thermoelectric conversion module of the present invention is a thermoelectric conversion module including: a thermoelectric conversion elements; a first electrode part disposed on one end side of the thermoelectric conversion elements; and a second electrode part disposed on an other end side of the thermoelectric conversion elements, in which the thermoelectric conversion elements are electrically connected to each other via the first electrode part and the second electrode part. A first insulating circuit board provided with a first insulating layer and the first electrode part formed on one surface of the first insulating layer is disposed on the one end side of the thermoelectric conversion elements. The first electrode part includes a first aluminum layer made of aluminum or an aluminum alloy, and a first sintered silver layer which is formed on a surface of the first aluminum layer on a side opposite to the first insulating layer and is formed of a sintered body of silver, the first aluminum layer has a thickness in a range of 50 $\mu$m or more and 2000 $\mu$m or less, and the first sintered silver layer has a thickness of 5 $\mu$m or more and a porosity of less than 10% at least in a region where the thermoelectric conversion element is disposed.

According to the thermoelectric conversion module of the present invention, the first insulating circuit board provided with the first insulating layer and the first electrode part formed on the one surface of the first insulating layer is disposed on the one end side of the thermoelectric conversion elements, the first electrode part includes the first aluminum layer made of aluminum or an aluminum alloy, and the first sintered silver layer which is laminated on the surface of the first aluminum layer on the side opposite to the first insulating layer and is formed of the sintered body of silver, the first aluminum layer has a thickness in a range of 50 $\mu$m or more and 2000 $\mu$m or less, and the first sintered silver layer has a thickness of 5 $\mu$m or more and a porosity of less than 10% at least in the region where the thermoelectric conversion element is disposed. Therefore, the first sintered silver layer becomes dense, and the thickness of the entire first electrode part is secured, so that the electric resistance can be lowered. Moreover, since there are few pores in the first sintered silver layer, deterioration of the thermoelectric conversion element due to the gas of the pores can be suppressed.

In addition, since the first electrode part is provided with the first aluminum layer made of aluminum or an aluminum alloy which is a relatively soft metal, compared to a case of using a substrate in which silver or copper is bonded to an insulating layer, it is possible to suppress damage to the insulating layer due to the difference in thermal expansion between the metal and the insulating layer.

Furthermore, since the first sintered silver layer is formed of the sintered body of a silver paste, a bonding temperature (sintering temperature) can be under a relatively low temperature condition, and deterioration of the thermoelectric conversion element at the time of bonding can be suppressed. In addition, since the first sintered silver layer itself is made of silver, the first sintered silver layer can be stably operated even at an operating temperature of about 500°C.

The thermoelectric conversion module of the present invention may have a configuration in which the thickness of the first sintered silver layer is 20 $\mu$m or more.

In this case, since the thickness of the first sintered silver layer is formed to be as relatively thick as 20 $\mu$m or more, conductivity is secured by the first sintered silver layer, and the electric resistance between the thermoelectric conversion elements can be kept low.

In addition, the thermoelectric conversion module of the present invention may have a configuration in which a second insulating circuit board provided with a second insulating layer and the second electrode part formed on one surface of the second insulating layer is disposed on the other end side of the thermoelectric conversion elements, the second electrode part includes a second aluminum layer made of aluminum or an aluminum alloy, and a second sintered silver layer which is formed on a surface of the second aluminum layer on a side opposite to the second insulating layer and is formed of a sintered body of silver, the second aluminum layer has a thickness in a range of 50 $\mu$m or more and 2000 $\mu$m or less, and the second sintered silver layer has a thickness of 5 $\mu$m or more and a porosity of less than 10% at least in a region where the thermoelectric conversion element is disposed.

In this case, the second insulating circuit board is disposed on the other end side of the thermoelectric conversion elements, the second electrode part of the second insulating circuit board includes the second aluminum layer made of aluminum or an aluminum alloy, and the second sintered silver layer which is laminated on the surface of the second aluminum layer on the side opposite to the second insulating layer and is formed of the sintered body of silver, the second aluminum layer has a thickness in a range of 50 $\mu$m or more and 2000 $\mu$m or less, and the second sintered silver layer has a thickness of 5 $\mu$m or more and a porosity P of less than 10% at least in the region where the thermoelectric conversion element is disposed. Therefore, the second sintered silver layer becomes dense, and the thickness of the entire second electrode part is secured, so that the electric resistance can be lowered. Moreover, since there are few pores in the second sintered silver layer, deterioration of the thermoelectric conversion element due to the gas of the pores can be suppressed.

In addition, since the second electrode part is provided with the second aluminum layer made of aluminum or an aluminum alloy which is a relatively soft metal, compared to a case of using a substrate in which silver or copper is bonded to an insulating layer, it is possible to suppress damage to the insulating layer due to the difference in thermal expansion between the metal and the insulating layer.

Furthermore, since the second sintered silver layer is formed of the sintered body of the silver paste, a bonding temperature (sintering temperature) can be under a relatively low temperature condition, and deterioration of the thermoelectric conversion element at the time of bonding can be suppressed. In addition, since the second sintered silver layer itself is made of silver, the second sintered silver layer can be stably operated even at an operating temperature of about 500°C.

Furthermore, the thermoelectric conversion module of the present invention has a configuration in which the thickness of the second sintered silver layer is 20 $\mu$m or more.

In this case, since the thickness of the second sintered silver layer is formed to be as relatively thick as 20 $\mu$m or more, conductivity is secured by the second sintered silver layer, and the electric resistance between the thermoelectric conversion elements can be kept low.

A method for producing a thermoelectric conversion module of the present invention is a method for producing a thermoelectric conversion module in which the thermoelectric conversion module includes a thermoelectric conversion elements, a first electrode part disposed on one end side of the thermoelectric conversion elements, and a second electrode part disposed on the other end side of the thermoelectric conversion elements, and the thermoelectric conversion elements are electrically connected to each other via the first electrode part and the second electrode part. A first insulating circuit board is provided to the thermoelectric conversion module, the first insulating circuit board including a first insulating layer and the first electrode part formed on one surface of the first insulating layer is disposed on the one end side of the thermoelectric conversion elements. The first electrode part includes a first aluminum layer made of aluminum or an aluminum alloy, and a first sintered silver layer which is laminated on a surface of the first aluminum layer on a side opposite to the first insulating layer and is formed of a sintered body of silver. The method includes: a silver paste applying step of applying a silver paste containing silver to one surface side of the first aluminum layer to a thickness of more than 5 $\mu$m; a sintering step of forming the first electrode part having the first aluminum layer and the first sintered silver layer by sintering the silver paste; a laminating step of laminating the first insulating layer on the one end side of the thermoelectric conversion elements via the first electrode part; and a thermoelectric conversion element bonding step of bonding the thermoelectric conversion elements by pressurizing and heating the thermoelectric conversion elements and the first insulating layer in a lamination direction. A glass-containing silver paste is applied to at least a lowermost layer in contact with the first aluminum layer in the silver paste applying step, and a pressurization load is in a range of 20 MPa or more and 50 MPa or less and a heating temperature is 300°C or higher and 400°C or lower in the thermoelectric conversion element bonding step. The first sintered silver layer has a thickness of 5 $\mu$m or more and a porosity of less than 10% at least in a region where the thermoelectric conversion element is disposed.

According to the method for producing the thermoelectric conversion module configured as described above, in the thermoelectric conversion element bonding step, since the pressurization load is in a range of 20 MPa or more and 50 MPa or less and the heating temperature is 300°C or higher and 400°C or lower, the thickness can be 5 $\mu$m or more and the porosity P can be less than 10% at least in the region of the first sintered silver layer where the thermoelectric conversion element is disposed. Moreover, since a relatively low temperature condition is applied, deterioration of the thermoelectric conversion element at the time of bonding (at the time of sintering) can be suppressed.

In addition, in the silver paste applying step, since the glass-containing silver paste is applied to at least the lowermost layer in contact with the first aluminum layer, an oxide film formed on the surface of the first aluminum layer due to a glass component of the glass-containing silver paste can be removed, so that the first aluminum layer and the first sintered silver layer can be reliably bonded.

The method for producing a thermoelectric conversion module of the present invention may further include: a blasting step of performing a blasting treatment on the first sintered silver layer after the sintering step.

In this case, since the blasting step of performing the blasting treatment on the first sintered silver layer is included, the electric resistance between the first sintered silver layer and the first aluminum layer decreases, so that the conductivity in the first electrode part can be improved.

In addition, in the method for producing a thermoelectric conversion module of the present invention, the thermoelectric conversion element may be disposed after applying a silver paste onto the first electrode part and drying the silver paste in the laminating step.

In this case, after the silver paste is applied onto the first electrode part and dried, the thermoelectric conversion element is disposed, and then the thermoelectric conversion element is bonded under the above-described conditions. Therefore, the sintered body of the silver paste applied onto the first electrode part can also be densified, and the porosity can be less than 10%.

Furthermore, in the method for producing a thermoelectric conversion module of the present invention, in the thermoelectric conversion module, a second insulating circuit board provided with a second insulating layer and the second electrode part formed on one surface of the second insulating layer is disposed on the other end side of the thermoelectric conversion elements, and the second electrode part includes a second aluminum layer made of aluminum or an aluminum alloy, and a second sintered silver layer which is laminated on a surface of the second aluminum layer on a side opposite to the second insulating layer and is formed of a sintered body of silver. In the silver paste applying step, a silver paste containing silver is applied to one surfaces of the first aluminum layer and the second aluminum layer to a thickness of 5 $\mu$m or more, and a glass-containing silver paste is applied to at least lowermost layers in contact with the first aluminum layer and the second aluminum layer. In the sintering step, the first electrode part including the first aluminum layer and the first sintered silver layer, and the second electrode part including the second aluminum layer and the second sintered silver layer are formed by sintering the silver paste. In the laminating step, the first insulating layer is laminated on the one end side of the thermoelectric conversion elements via the first electrode part, and the second insulating layer is laminated on the other end side of the thermoelectric conversion elements via the second electrode part. In the thermoelectric conversion element bonding step, the first electrode part and the thermoelectric conversion element, and the thermoelectric conversion element and the second electrode part are bonded by pressurizing and heating the first insulating layer, the thermoelectric conversion element, and the second insulating layer in the lamination direction. In the thermoelectric conversion element bonding step, the pressurization load is in the range of 20 MPa or more and 50 MPa or less, the heating temperature is 300°C or higher and 400°C or lower, and the first sintered silver layer and the second sintered silver layer have a thickness of 5 $\mu$m or more and a porosity of less than 10% at least in regions where the thermoelectric conversion element is disposed.

In this case, also in the second sintered silver layer of the second electrode part disposed on the other end side of the thermoelectric conversion elements, the thickness can be 5 $\mu$m or more and the porosity P can be less than 10% at least in the region where the thermoelectric conversion element is disposed. Moreover, since a relatively low temperature condition is applied, deterioration of the thermoelectric conversion element at the time of bonding (at the time of sintering) can be suppressed.

In addition, in the silver paste applying step, since the glass-containing silver paste is applied to at least the lowermost layers in contact with the first aluminum layer and the second aluminum layer, oxide films formed on the surfaces of the first aluminum layer and the second aluminum layer due to the glass component of the glass-containing silver paste can be removed, so that the first aluminum layer and the first sintered silver layer, and the second aluminum layer and the second sintered silver layer can be reliably bonded.

The method for producing a thermoelectric conversion module of the present invention may further include: a blasting step of performing a blasting treatment on the first sintered silver layer and the second sintered silver layer after the sintering step.

In this case, since the blasting step of performing the blasting treatment on the first sintered silver layer and the second sintered silver layer is included, the electric resistance between the first sintered silver layer and the first aluminum layer and between the second sintered silver layer and the second aluminum layer decreases, so that the conductivity in the first electrode part and the second electrode part can be improved.

In the method for producing a thermoelectric conversion module of the present invention, the thermoelectric conversion element may be disposed after applying a silver paste onto the second electrode part and drying the silver paste in the laminating step.

In this case, after the silver paste is applied onto the second electrode part and dried, the thermoelectric conversion element is disposed, and then the thermoelectric conversion element is bonded under the above-described conditions. Therefore, the sintered body of the silver paste applied onto the second electrode part can also be densified, and the porosity can be less than 10%.

Advantageous Effects of Invention

According to the present invention, it is possible to provide a thermoelectric conversion module in which the electric resistance in an electrode part is low, deterioration of a thermoelectric conversion element at the time of bonding is suppressed, and excellent thermoelectric conversion efficiency is achieved, and a method for producing a thermoelectric conversion module.

BRIEF DESCRIPTION OF DRAWINGS

FIG. 1 is a schematic explanatory view of a thermoelectric conversion module according to an embodiment of the present invention.
FIG. 2 is a flowchart showing a method for producing a thermoelectric conversion module according to the embodiment of the present invention.
FIG. 3 is a schematic explanatory view of the method for producing a thermoelectric conversion module according to the embodiment of the present invention.
FIG. 4 is a schematic explanatory view of the method for producing a thermoelectric conversion module according to the embodiment of the present invention.
FIG. 5 is a schematic explanatory view of a thermoelectric conversion module according to another embodiment of the present invention.

BEST MODE FOR CARRYING OUT THE INVENTION

Hereinafter, embodiments of the present invention will be described with reference to the accompanying drawings. Each of the embodiments described below is specifically described for better understanding of the spirit of the invention, and does not limit the present invention unless otherwise specified. In addition, in the drawings used in the following description, in order to facilitate the understanding of the features of the present invention, there is a case where a part which becomes a main part is shown in an enlarged manner for convenience, and the dimensional ratio of each component is not necessarily the same as the reality.

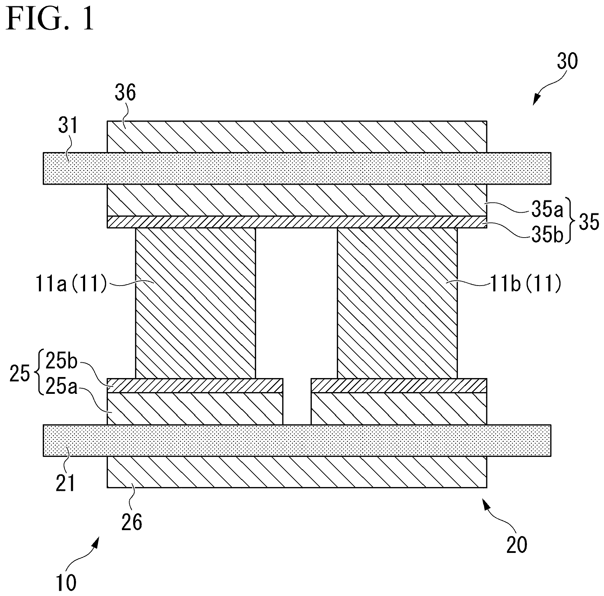

As illustrated in FIG. 1, a thermoelectric conversion module 10 according to the present embodiment includes a plurality of columnar thermoelectric conversion elements 11, a first heat transfer plate 20 disposed on one end side (lower side in FIG. 1) of the thermoelectric conversion elements 11 in a longitudinal direction thereof, and a second heat transfer plate 30 disposed on the other end side (upper side in FIG. 1) of the thermoelectric conversion elements 11 in the longitudinal direction.

As illustrated in FIG. 1, a first electrode part 25 is formed in the first heat transfer plate 20 provided on the one end side of the thermoelectric conversion elements 11, a second electrode part 35 is formed in the second heat transfer plate 30 provided on the other end side of the thermoelectric conversion elements 11, and the plurality of columnar thermoelectric conversion elements 11 are electrically connected in series by the first and second electrode parts 25 and 35.

The first heat transfer plate 20 is formed as a first insulating circuit board provided with a first insulating layer 21 and the first electrode part 25 formed on one surface (the upper surface in FIG. 1) of the first insulating layer 21.

In the present embodiment, in the first insulating circuit board that becomes the first heat transfer plate 20, as illustrated in FIG. 1, a first radiating layer 26 is formed on the other surface (the lower surface in FIG. 1) of the first insulating layer 21.

The first insulating layer 21 is made of a highly insulating ceramic material such as aluminum nitride (AlN), silicon nitride ($Si_3N_4$), and alumina ($Al_2O_3$), or an insulating resin. In the present embodiment, the first insulating layer 21 is made of aluminum nitride (AlN). The thickness of the first insulating layer 21 made of aluminum nitride is in a range of 100 $\mu$m or more and 2000 $\mu$m or less.

As illustrated in FIG. 1, the first electrode part 25 includes a first aluminum layer 25a disposed on the one surface of the first insulating layer 21, and a first sintered silver layer 25b which is laminated on the surface of the first aluminum layer 25a on the side opposite to the first insulating layer 21 and is formed of a sintered body of silver. The first electrode part 25 is formed in a pattern on the one surface (the upper surface in FIG. 1) of the first insulating layer 21.

The first aluminum layer 25a has a thickness in a range of 50 $\mu$m or more and 2000 $\mu$m or less.

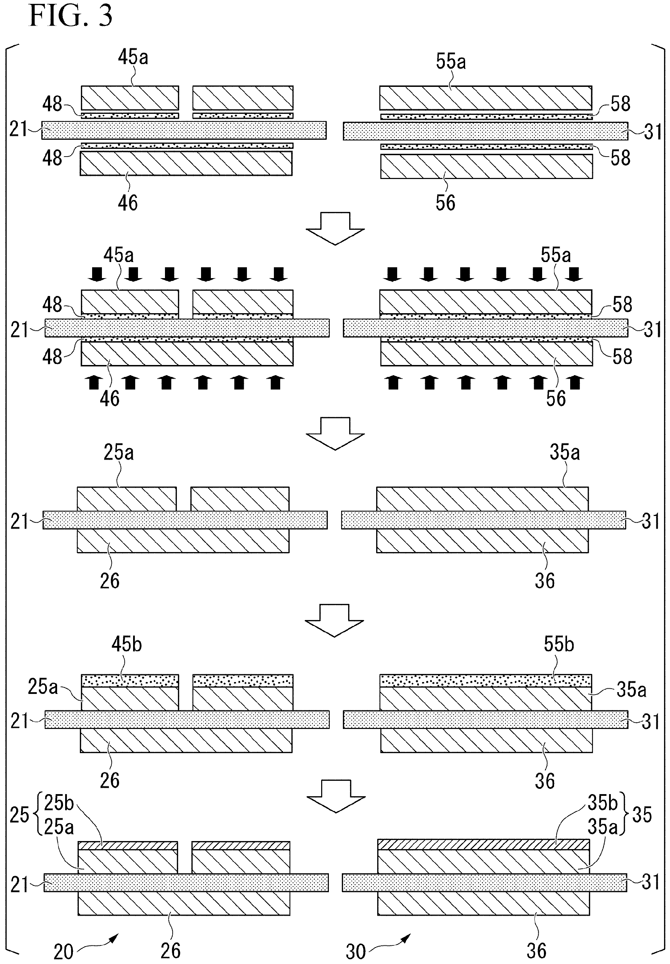

As illustrated in FIG. 3, the first aluminum layer 25a is formed by bonding a first aluminum plate 45a to the one surface of the first insulating layer 21. In the present embodiment, the first aluminum plate 45a is made of aluminum having a purity of 99 mass% or more or aluminum having a purity of 99.99 mass% or more.

The first sintered silver layer 25b is made of the sintered body of silver, and the lowermost layer thereof in contact with one surface of the first aluminum layer 25a is formed of a sintered body of a glass-containing silver paste containing a glass component. In the present embodiment, the entire first sintered silver layer 25b is formed of the sintered body of the glass-containing silver paste.

The first sintered silver layer 25b has a thickness of 5 $\mu$m or more at least in a region where the thermoelectric conversion element 11 is disposed.

The thickness of the first sintered silver layer 25b is preferably 20 $\mu$m or more. By setting the thickness of the first sintered silver layer 25b to 20 $\mu$m or more, the electric resistance can be reliably reduced. In addition, the thickness of the first sintered silver layer 25b is preferably 100 $\mu$m or less. By setting the thickness of the first sintered silver layer 25b to 100 $\mu$m or less, it is possible to suppress generation of a large thermal stress in the thermoelectric conversion element 11 when a thermal cycle is applied, and to prevent occurrence of breaking.

Therefore, the thickness of the first sintered silver layer 25b is preferably in the range of 20 $\mu$m or more and 100 $\mu$m or less. The lower limit of the thickness of the first sintered silver layer 25b is more preferably 30 $\mu$m or more, and the upper limit of the thickness of the first sintered silver layer 25b is more preferably 60 $\mu$m or less.

The first sintered silver layer 25b has a porosity P of less than 10% at least in the region where the thermoelectric conversion element 11 is disposed. The porosity P of the first sintered silver layer 25b can be calculated as follows.

After mechanically polishing a cross section of the first sintered silver layer 25b, Ar ion etching (Cross Section Polisher SM-09010 manufactured by JEOL Ltd.) was performed thereon, and the cross section was observed using a laser microscope (VK X-200 manufactured by Keyence Corporation). The obtained image was binarized, white parts were determined as Ag, and black parts were determined as pores. From the binarized image, the area of the black parts was obtained, and the porosity was calculated by the following formula. Measurement was performed at five cross sections, and the porosities of the cross sections were arithmetically averaged to obtain the porosity of the first sintered silver layer 25b.

$$\text{Porosity P (\%)} = \text{area of black parts (pore) / observation area of the first sintered silver layer 21b} \times 100$$

Since the first aluminum layer 25a is made of aluminum or an aluminum alloy, an aluminum oxide film naturally generated in the atmosphere is formed on the surface of the first aluminum layer 25a. In the present embodiment, since the lowermost layer of the first sintered silver layer 25b is formed of the sintered body of the glass-containing silver paste, the aluminum oxide film is removed by the glass component, and the first aluminum layer 25a and the first sintered silver layer 25b are firmly bonded to each other.

The first radiating layer 26 is made of aluminum or an aluminum alloy. In the present embodiment, similarly to the first aluminum layer 25a, the first radiating layer 26 is formed by bonding a radiating aluminum plate 46 to the other surface of the first insulating layer 21. In the present embodiment, the radiating aluminum plate 46 is made of aluminum having a purity of 99 mass% or more or aluminum having a purity of 99.99 mass% or more.

The second heat transfer plate 30 is formed as a second insulating circuit board provided with a second insulating layer 31 and the second electrode part 35 formed on one surface (the lower surface in FIG. 1) of the second insulating layer 31.

In the present embodiment, in the second insulating circuit board that becomes the second heat transfer plate 30, as illustrated in FIG. 1, a second radiating layer 36 is formed on the other surface (the upper surface in FIG. 1) of the second insulating layer 31.

The second insulating layer 31 is made of a highly insulating ceramic material such as aluminum nitride (AlN), silicon nitride ($Si_3N_4$), and alumina ($Al_2O_3$), or an insulating resin. In the present embodiment, the second insulating layer 31 is made of aluminum nitride (AlN). The thickness of the second insulating layer 31 made of aluminum nitride is in a range of 100 $\mu$m or more and 2000 $\mu$m or less.

As illustrated in FIG. 1, the second electrode part 35 includes a second aluminum layer 35a disposed on the one surface of the second insulating layer 31, and a second sintered silver layer 35b which is laminated on the surface of the second aluminum layer 35a on the side opposite to the second insulating layer 31 and is formed of a sintered body of silver. The second electrode part 35 is formed in a pattern on the one surface (the upper surface in FIG. 1) of the second insulating layer 31.

The second aluminum layer 35a has a thickness in a range of 50 $\mu$m or more and 2000 $\mu$m or less.

As illustrated in FIG. 3, the second aluminum layer 35a is formed by bonding a second aluminum plate 55a to the one surface of the second insulating layer 31. In the present embodiment, the second aluminum plate 55a is made of aluminum having a purity of 99 mass% or more or aluminum having a purity of 99.99 mass% or more.

The second sintered silver layer 35b is made of the sintered body of silver, and the lowermost layer thereof in contact with one surface of the second aluminum layer 35a is formed of a sintered body of a glass-containing silver paste containing a glass component. In the present embodiment, the entire second sintered silver layer 35b is formed of the sintered body of the glass-containing silver paste.

The second sintered silver layer 35b has a thickness of 5 $\mu$m or more at least in a region where the thermoelectric conversion element 11 is disposed.

The thickness of the second sintered silver layer 35b is preferably 20 $\mu$m or more. By setting the thickness of the second sintered silver layer 35b to 20 $\mu$m or more, the electric resistance can be reliably reduced. The thickness of the second sintered silver layer 35b is preferably 100 $\mu$m or less. By setting the thickness of the first sintered silver layer 35b to 100 $\mu$m or less, it is possible to suppress generation of a large thermal stress in the thermoelectric conversion element 11 when a thermal cycle is applied, and to prevent occurrence of breaking.

Therefore, the thickness of the second sintered silver layer 35b is preferably in the range of 20 $\mu$m or more and 100 $\mu$m or less. The lower limit of the thickness of the second sintered silver layer 35b is more preferably 30 $\mu$m or more, and the upper limit of the thickness of the second sintered silver layer 35b is more preferably 60 $\mu$m or less.

The second sintered silver layer 35b has a porosity P of less than 10% at least in the region where the thermoelectric conversion element 11 is disposed. The porosity P of the second sintered silver layer 35b can be calculated by the same method as that for the first sintered silver layer 25b.

Since the second aluminum layer 35a is made of aluminum or an aluminum alloy, an aluminum oxide film naturally generated in the atmosphere is formed on the surface of the second aluminum layer 35a. In this embodiment, since the lowermost layer of the second sintered silver layer 35b is formed of the sintered body of the glass-containing silver paste, the aluminum oxide film is removed by the glass component, and the second aluminum layer 35a and the second sintered silver layer 35b are firmly bonded to each other.

The second radiating layer 36 is made of aluminum or an aluminum alloy. In the present embodiment, similarly to the second aluminum layer 35a, the second radiating layer 36 is formed by bonding a radiating aluminum plate 56 to the other surface of the second insulating layer 31. In the present embodiment, the radiating aluminum plate 56 is made of aluminum having a purity of 99 mass% or more or aluminum having a purity of 99.99 mass% or more.

The thermoelectric conversion elements 11 include n-type thermoelectric conversion elements 11a and p-type thermoelectric conversion elements 11b, and the n-type thermoelectric conversion elements 11a and the p-type thermoelectric conversion elements 11b are alternately arranged.

Metallized layers (not illustrated) are respectively formed on one end surface and the other end surface of the thermoelectric conversion element 11. As the metallized layer, for example, nickel, silver, cobalt, tungsten, molybdenum, or a nonwoven fabric made of fibers of such metals can be used. It is preferable that the outermost surface of the metallized layer (bonding surface to the first electrode part 25 and the second electrode part 35) is made of Au or Ag.

For example, the n-type thermoelectric conversion element 11a and the p-type thermoelectric conversion element 11b are formed of sintered bodies of tellurium compounds, skutterudites, filled skutterudites, Heuslers, half-Heuslers, clathrates, silicides, oxides, or silicon-germanium.

As a material of the n-type thermoelectric conversion element 11a, for example, $Bi_2Te_3$, $PbTe$, $La_3Te_4$, $CoSb_3$, $FeVAl$, $ZrNiSn$, $Ba_8Al_{16}Si_{30}$, $Mg_2Si$, $FeSi_2$, $SrTiO_3$, $CaMnO_3$, $ZnO$, or $SiGe$ is used.

As a material of the p-type thermoelectric conversion element 11b, for example, $Bi_2Te_3$, $Sb_2Te_3$, $PbTe$, TAGS (= Ag-Sb-Ge-Te), $Zn_4Sb_3$, $CoSb_3$, $CeFe_4Sbi_2$, $Yb_{14}MnSb_{11}$, $FeVAl$, $MnSi_{1.73}$, $FeSi_2$, $NaxCoO_2$, $Ca_3Co_4O_7$, $Bi_2Sr_2Co_2O_7$, or $SiGe$ is used.

There are compounds that can take both n-type and p-type depending on the dopant, and compounds that have either n-type or p-type properties.

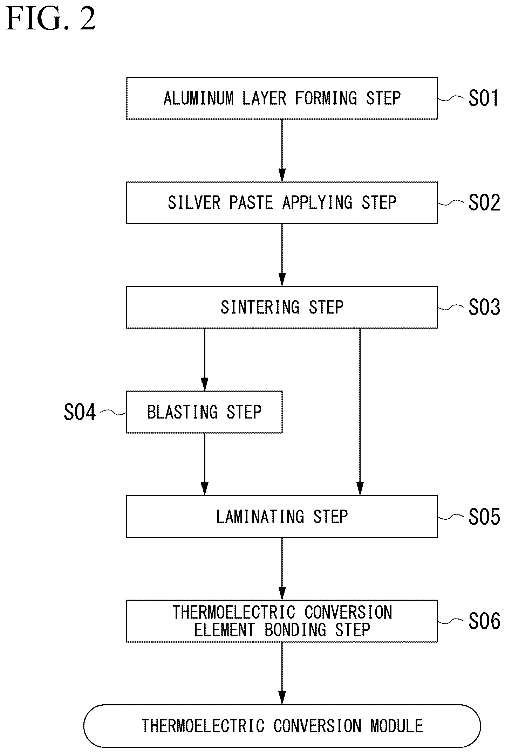

Next, a method for producing the thermoelectric conversion module 10, which is the present embodiment described above, will be described with reference to FIGS. 2 to 4.

(Aluminum Layer Forming step S01)

First, as illustrated in FIG. 3, the first aluminum layer 25a is formed by bonding the first aluminum plate 45a to the one surface of the first insulating layer 21, and the second aluminum layer 35a is formed by bonding the second aluminum plate 55a to the one surface of the second insulating layer 31.

In the present embodiment, as illustrated in FIG. 3, the first radiating layer 26 is formed by bonding the radiating aluminum plate 46 to the other surface of the first insulating layer 21, and the second radiating layer 36 is formed by bonding the radiating aluminum plate 56 to the other surface of the second insulating layer 31.

A method of bonding the first insulating layer 21, the first aluminum plate 45a, and the radiating aluminum plate 46, and a method of bonding the second insulating layer 31, the second aluminum plate 55a, and the radiating aluminum plate 56 are not particularly limited, and for example, bonding using an Al-Si-based brazing material or solid phase diffusion bonding may be applied. Furthermore, bonding may be performed by a transient liquid phase (TLP) bonding method in which additive elements such as Cu and Si are fixed to a bonding surface, and these additive elements are diffused to melt and solidify.

In the present embodiment, as illustrated in FIG. 3, using Al-Si-based brazing materials 48 and 58, the first insulating layer 21, the first aluminum plate 45a, and the radiating aluminum plate 46 are bonded together, and the second insulating layer 31, the second aluminum plate 55a, and the radiating aluminum plate 56 are bonded together.

(Silver Paste Applying Step S02)

First, a silver paste containing silver is applied to each of the one surface of the first aluminum layer 25a and the one surface of the second aluminum layer 35a to a thickness exceeding 5 $\mu$m. The application method is not particularly limited, and various means such as a screen-printing method, an offset printing method, and a photosensitive process can be adopted. At this time, the glass-containing silver paste having the glass component is applied to the lowermost layers in contact with the first aluminum layer 25a and the second aluminum layer 35a.

In order to cause the application thickness to exceed 5 $\mu$m, paste application and drying may be repeated. In this case, a glass-containing paste may be applied to the lowermost layers in contact with the first aluminum layer 25a and the second aluminum layer 35a, and thereafter a silver paste that does not contain the glass component may be applied.

In the present embodiment, as illustrated in FIG. 3, glass-containing silver pastes 45b and 55b are respectively applied to the one surface of the first aluminum layer 25a and the one surface of the second aluminum layer 35a to a thickness exceeding 5 $\mu$m.

The application thickness is preferably 7 $\mu$m or more.

The glass-containing silver paste for forming the first sintered silver layer 25b and the second sintered silver layer 35b will be described.

This glass-containing silver paste contains a silver powder, a glass powder, a resin, a solvent, and a dispersant, the amount of the powder component including the silver powder and the glass powder is 60 mass% or more and 90 mass% or less of the entire glass-containing silver paste, and the balance includes the resin, the solvent, and the dispersant.

In the present embodiment, the amount of the powder component including the silver powder and the glass powder is 85 mass% of the entire glass-containing silver paste.

The viscosity of the glass-containing silver paste is adjusted to 10 Pa·s or more and 500 Pa·s or less, and more preferably 50 Pa·s or more and 300 Pa·s or less.

The silver powder has a particle size of 0.05 $\mu$m or more and 1.0 $\mu$m or less, and in the present embodiment, a silver powder having an average particle size of 0.8 $\mu$m was used.

The glass powder contains, for example, one or more of lead oxide, zinc oxide, silicon oxide, boron oxide, phosphorus oxide, and bismuth oxide. In the present embodiment, a glass powder primarily containing lead oxide, zinc oxide, and boron oxide and having an average particle size of 0.5 $\mu$m was used.

The weight ratio A/G between the weight A of the silver powder and the weight G of the glass powder is adjusted within a range of 80/20 to 99/1, and in the present embodiment, was A/G = 80/5.

A solvent having a boiling point of 200°C or higher is suitable, and in the present embodiment, diethylene glycol dibutyl ether is used.

The resin is used to adjust the viscosity of the glass-containing silver paste, and a resin that is decomposed at 400°C or higher is suitable. In the present embodiment, ethyl cellulose is used.

In the present embodiment, a dicarboxylic acid-based dispersant is added. The glass-containing silver paste may be formed without adding a dispersant.

This glass-containing silver paste is prepared by premixing a mixed powder in which the silver powder and the glass powder are mixed and an organic mixture in which the solvent and the resin are mixed with the dispersant using a mixer, kneading and mixing the obtained premixed mixture using a roll mill, and thereafter filtering the obtained kneaded product using a paste filter.

(Sintering Step S03)

Next, a heating treatment is performed in a state where the silver pastes (the glass-containing silver pastes 45b and 55b) are respectively applied to the one surface of the first aluminum layer 25a and the one surface of the second aluminum layer 35a such that the silver pastes (the glass-containing silver pastes 45b and 55b) are sintered. Before the sintering, a drying treatment for removing the solvent of the silver pastes (the glass-containing silver pastes 45b and 55b) may be performed. Accordingly, the first sintered silver layer 25b having a thickness of 5 $\mu$m or more is

laminated on the first aluminum layer 25a, and the second sintered silver layer 35b having a thickness of 5 $\mu$m or more is laminated on the second aluminum layer 35a, whereby the first electrode part 25 and the second electrode part 35 are formed.

In the sintering step S03, sintering is preferably performed under conditions of an air atmosphere, a heating temperature of 400°C or higher and 600°C or lower, and a holding time of 1 minute to 60 minutes at the heating temperature.

(Blasting Step S04)

Next, a blasting treatment may be performed on the first sintered silver layer 25b and the second sintered silver layer 35b as necessary. For example, in a case where the thickness of the first sintered silver layer 25b and the second sintered silver layer 35b is 5 $\mu$m or more and less than 20 $\mu$m, it is preferable to perform a blasting step S04.

In a case of performing the blasting step S04, irregularities corresponding to blasting abrasive particles to be collided are formed on the surfaces of the first sintered silver layer 25b and the second sintered silver layer 35b after the blasting treatment.

The surface roughness Ra of the first sintered silver layer 25b and the second sintered silver layer 35b after the blasting treatment may be 0.35 $\mu$m or more and 1.50 $\mu$m or less. By setting the surface roughness Ra after the blasting treatment to 0.35 $\mu$m or more, the electric resistance between the first sintered silver layer 25b and the first aluminum layer 25a and between the second sintered silver layer 35b and the second aluminum layer 35a can be sufficiently reduced. On the other hand, by setting the surface roughness Ra after the blasting treatment to 1.50 $\mu$m or less, the thermoelectric conversion element 11 can be favorably bonded.

In the blasting treatment step S04, as the blasting particles, glass particles such as silica having a new Mohs hardness of 2 to 7, ceramic particles, metal particles, resin beads, or the like can be used. In the present embodiment, glass particles are used. Moreover, the particle size of the blasting particles are set to be in a range of 20 $\mu$m or more and 150 $\mu$m or less.

A blast pressure is set to be in a range of 0.2 MPa or more and 0.8 MPa or less, and a processing time is set to be in a range of 2 seconds or longer and 60 seconds or shorter.

In a case where the thickness of the first sintered silver layer 25b and the second sintered silver layer 35b is less than 5 $\mu$m, parts of the first sintered silver layer 25b and the second sintered silver layer 35b are buried in the first aluminum layer 25a and the second aluminum layer 35a by the blasting treatment, and the bonding between the thermoelectric conversion element 11 and the first electrode part 25 and between the thermoelectric conversion element 11 and the second electrode part 35 is reduced.

After the blasting step S04, a silver paste that does not contain glass may be applied, dried, and sintered to cause the thickness of the first sintered silver layer 25b and the second sintered silver layer 35b to be 5 $\mu$m or more.

Whether or not the blast step S04 is performed is preferably determined based on the following criteria.

In the thermoelectric conversion module 10 according to the present embodiment, it is preferable that the first sintered silver layer 25b and the second sintered silver layer 35b are configured so that the electric resistance between the two connected thermoelectric conversion elements 11 and 11 is 1/10 or less of the electric resistance of the thermoelectric conversion element 11 itself. Specifically, the electric resistance between the two connected thermoelectric conversion elements 11 and 11 is preferably in a range of 1 m$\Omega$ or more and 1$\Omega$ or less.

In a case where the thickness of the first sintered silver layer 25b and the second sintered silver layer 35b is large and conductivity is secured in the first sintered silver layer 25b and the second sintered silver layer 35b, there is no need to perform the blasting step S04. On the other hand, in a case where the thickness of the first sintered silver layer 25b and the second sintered silver layer 35b is small and the first sintered silver layer 25b and the second sintered silver layer 35b have insufficient conductivity, it is preferable to perform the blasting step S04 to secure conductivity by the first sintered silver layer 25b and the first aluminum layer 25a, and by the second sintered silver layer 35b and the second aluminum layer 35a.

In a case where the blasting step S04 is performed, in a case where the thermal cycle is applied to the thermoelectric conversion module 10, there is concern that the effect of the blasting step S04 may be reduced. For this reason, it is preferable not to perform the blasting step S04 in applications in which a thermal cycle is applied.

(Laminating Step S05)

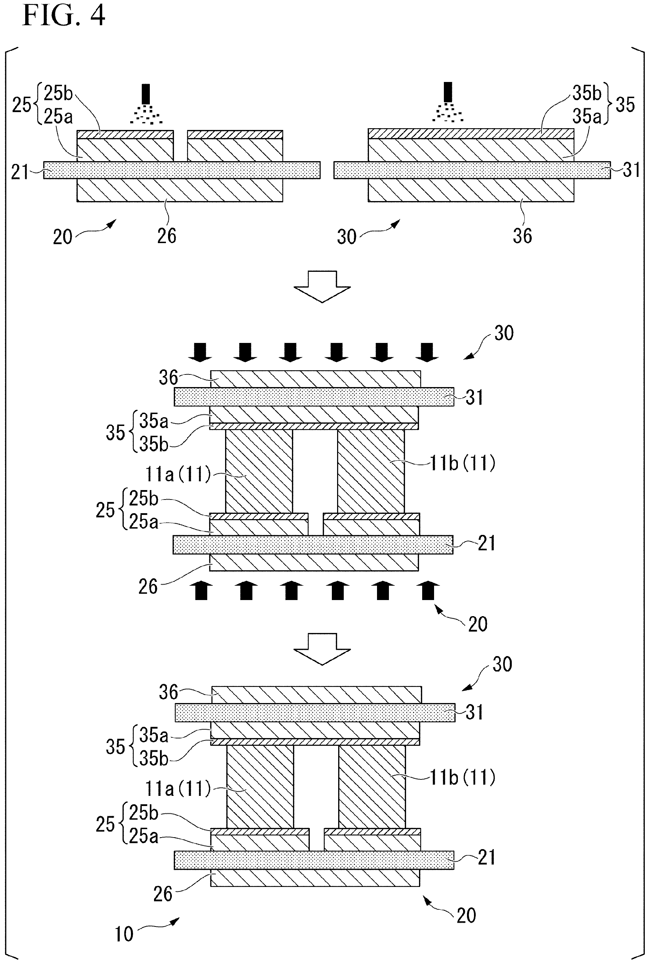

Next, the first insulating layer 21 is laminated on the one end side (lower side in FIG. 4) of the thermoelectric conversion elements 11 via the first electrode part 25, the second insulating layer 31 is laminated on the other end side (upper side in FIG. 4) of the thermoelectric conversion elements 11 via the second electrode part 35.

(Thermoelectric Conversion Element Bonding Step S06)

Next, the first insulating layer 21, the thermoelectric conversion element 11, and the second insulating layer 31 are pressurized and heated in the lamination direction, whereby the thermoelectric conversion element 11 and the first electrode part 25 are bonded and the thermoelectric conversion element 11 and the second electrode part 35 are bonded. In the present embodiment, the thermoelectric conversion element 11 and the first and second electrode parts 25 and 35 are bonded by solid phase diffusion bonding.

At least in the region of the first sintered silver layer 25b where the thermoelectric conversion element 11 is disposed, the thickness is 5 $\mu$m or more and the porosity P is less than 10%. Similarly, at least in the region of the second sintered silver layer 35b where the thermoelectric conversion element 11 is disposed, the thickness is 5 $\mu$m or more and the porosity P is less than 10%.

In this thermoelectric conversion element bonding step S06, the pressurization load is in a range of 20 MPa or more and 50 MPa or less, and the heating temperature is in the range of 300°C or higher and 400°C or lower. In the present embodiment, the holding time at the heating temperature mentioned above is 5 minutes or longer and 60 minutes or shorter, and the atmosphere is a vacuum atmosphere.

When the pressurization load in the thermoelectric conversion element bonding step S06 is less than 20 MPa, there is concern that the porosity of the first sintered silver layer 25b and the second sintered silver layer 35b may not be less than 10%. On the other hand, when the pressurization load in the thermoelectric conversion element bonding step S06 exceeds 50 MPa, there is concern that breaking may occur in the thermoelectric conversion element 11 or the first insulating layer 21 and the second insulating layer 31 made of aluminum nitride. Furthermore, there is concern that the first aluminum layer 25a and the second aluminum layer 35a may be deformed.

For this reason, in the present embodiment, the pressurization load in thermoelectric conversion element bonding step S06 is set to be in a range of 20 MPa or more and 50 MPa or less.

In order to cause the porosity P of the first sintered silver layer 25b and the second sintered silver layer 35b to be reliably less than 10%, the lower limit of the pressurization load in the thermoelectric conversion element bonding step S06 is preferably 30 MPa or more. On the other hand, in order to reliably suppress the occurrence of breaking in the thermoelectric conversion element 11 or the first insulating layer 21 and the second insulating layer 31 made of aluminum nitride, the upper limit of the pressurization load in the thermoelectric conversion element bonding step S06 is preferably 40 MPa or less.

When the heating temperature in the thermoelectric conversion element bonding step S06 is less than 300°C, there is concern that the thermoelectric conversion element 11 and the first and second electrode parts 25 and 35 may not be bonded. On the other hand, when the heating temperature in the thermoelectric conversion element bonding step S06 exceeds 400°C, the first aluminum layer 25a and the second aluminum layer 35a are softened and deformed, and there is concern that the first electrode part 25 and the second electrode part 35 formed in a pattern may be short-circuited.

For this reason, in the present embodiment, the heating temperature in the thermoelectric conversion element bonding step S06 is set to be in a range of 300°C or higher and 400°C or lower.

In order to reliably bond the thermoelectric conversion elements 11 to the first and second electrode parts 25 and 35, the lower limit of the heating temperature in the thermoelectric conversion element bonding step S06 is preferably set to 330°C or higher. On the other hand, in order to reliably suppress deformation of the first aluminum layer 25a and the second aluminum layer 35a, the upper limit of the heating temperature in the thermoelectric conversion element bonding step S06 is preferably set to 370°C or lower.

As described above, the thermoelectric conversion module 10 according to the present embodiment is produced.

In the thermoelectric conversion module 10 according to the present embodiment obtained as above, conversion between thermal energy and electrical energy is performed using the first heat transfer plate 20 side as a low temperature part and the second heat transfer plate 30 side as a high temperature part.

In the thermoelectric conversion module 10 according to the present embodiment configured as described above, the first insulating circuit board provided with the first insulating layer 21 and the first electrode part 25 formed on the one surface of the first insulating layer 21 is disposed on the one end side of the thermoelectric conversion elements 11. The first electrode part 25 includes the first aluminum layer 25a made of aluminum or an aluminum alloy, and the first sintered silver layer 25b which is laminated on the surface of the first aluminum layer 25a on the side opposite to the first insulating layer 21 and is formed of the sintered body of silver. The first aluminum layer 25a has a thickness in a range of 50 $\mu$m or more and 2000 $\mu$m or less. The first sintered silver layer 25b has a thickness of 5 $\mu$m or more and a porosity P of less than 10% at least in the region where the thermoelectric conversion element 11 is disposed. Therefore, the first sintered silver layer 25b becomes dense, and the thickness of the entire first electrode part 25 is secured, so that the electric resistance can be lowered. Moreover, since there are few pores in the first sintered silver layer 25b, deterioration of the thermoelectric conversion element 11 due to the gas of the pores can be suppressed.

In addition, since the first electrode part 25 is provided with the first aluminum layer 25a made of aluminum or an aluminum alloy which is a relatively soft metal, compared to a case of using a substrate in which silver or copper is bonded to the first insulating layer 21, it is possible to suppress damage to the first insulating layer 21 due to the difference in thermal expansion between the metal and the first insulating layer 21.

Furthermore, since the first sintered silver layer 25b is formed of the sintered body of the silver paste, a bonding temperature (sintering temperature) can be under a relatively low temperature condition, and deterioration of the thermoelectric conversion element 11 at the time of bonding can be suppressed.

In addition, since the first sintered silver layer 25b itself is made of silver, the first sintered silver layer 25b can be stably operated even at an operating temperature of about 500°C.

In addition, in the present embodiment, the second insulating circuit board provided with the second insulating layer 31 and the second electrode part 35 formed on the one surface of the second insulating layer 31 is disposed on the other end side of the thermoelectric conversion elements 11. The second electrode part 35 includes the second aluminum layer 35a made of aluminum or an aluminum alloy, and the second sintered silver layer 35b which is laminated on the surface of the second aluminum layer 35a on the side opposite to the second insulating layer 31 and is formed of the sintered body of silver. The second aluminum layer 35a has a thickness in a range of 50 $\mu$m or more and 2000 $\mu$m or less. The second sintered silver layer 35b has a thickness of 5 $\mu$m or more and a porosity P of less than 10% at least in the region where the thermoelectric conversion element 11 is disposed. Therefore, the second sintered silver layer 35b becomes dense, and the thickness of the entire second electrode part 35 is secured, so that the electric resistance can be lowered. Moreover, since there are few pores in the second sintered silver layer 35b, deterioration of the thermoelectric conversion element 11 due to the gas of the pores can be suppressed.

In addition, since the second electrode part 35 is provided with the second aluminum layer 35a made of aluminum or an aluminum alloy which is a relatively soft metal, compared to a case of using a substrate in which silver or copper is bonded to the second insulating layer 31, it is possible to suppress damage to the second insulating layer 31 due to the difference in thermal expansion between the metal and the second insulating layer 31.

Furthermore, since the second sintered silver layer 35b is formed of the sintered body of the silver paste, a bonding temperature (sintering temperature) can be under a relatively low temperature condition, and deterioration of the thermoelectric conversion element 11 at the time of bonding can be suppressed. In addition, since the second sintered silver layer 35b itself is made of silver, the second sintered silver layer 35b can be stably operated even at an operating temperature of about 500°C.

In the thermoelectric conversion module 10 according to the present embodiment, in a case where the thickness of the first sintered silver layer 25b and the second sintered silver layer 35b is 20 $\mu$m or more, the conductivity is secured by the first sintered silver layer 25b and the second sintered silver layer 35b, and the electric resistance between the thermoelectric conversion elements 11 can be kept low. Moreover, it is not necessary to perform the blasting step S04 on the first sintered silver layer 25b and the second sintered silver layer 35b, and the thermoelectric conversion module 10 can also be used favorably in applications in which a thermal cycle is applied.

According to the method for producing the thermoelectric conversion module according to the present embodiment, in the thermoelectric conversion element bonding step S06, since the pressurization load is in a range of 20 MPa or more and 50 MPa or less and the heating temperature is 300°C or higher and 400°C or lower, the thickness can be 5 $\mu$m or more and the porosity P can be less than 10% at least in the regions of the first sintered silver layer 25b and the second sintered silver layer 35b where the thermoelectric conversion element 11 is disposed. Moreover, since a relatively low temperature condition is applied, deterioration of the thermoelectric conversion element 11 at the time of bonding (at the time of sintering) can be suppressed.

In addition, in the silver paste applying step S02, since the glass-containing silver paste is applied to at least the lowermost layers in contact with the first aluminum layer 25a and the second aluminum layer 35a, the oxide films formed on the surfaces of the first aluminum layer 25a and the second aluminum layer 35a due to the glass component of the glass-containing silver paste can be removed, so that the first aluminum layer 25a and the first sintered silver layer 25b, and the second aluminum layer 35a and the second sintered silver layer 35b can be reliably bonded.

Furthermore, in the present embodiment, for example, in a case where the thickness of the first sintered silver layer 25b and the second sintered silver layer 35b is 5 $\mu$m or more and less than 20 $\mu$m, in a case where the blasting step S04 for performing the blasting treatment is performed on the first sintered silver layer 25b and the second sintered silver layer 35b, the electric resistance between the first sintered silver layer 25b and the first aluminum layer 25a and between the second sintered silver layer 35b and the second aluminum layer 35a decreases, so that the conductivity in the first electrode part 25 and the second electrode part 35 can be improved.

In addition, since the thickness of the first sintered silver layer 25b and the second sintered silver layer 35b are 5 $\mu$m or more, parts of the first sintered silver layer 25b and the second sintered silver layer 35b are not buried in the first aluminum layer 25a and the second aluminum layer 35a by the blasting treatment, and the bonding between the thermoelectric conversion element 11 and the first electrode part 25 and between the thermoelectric conversion element 11 and the second electrode part 35 is not reduced.

In a case where the thickness of the first sintered silver layer 25b and the second sintered silver layer 35b is 20 $\mu$m or more, the conductivity is sufficiently secured in the first sintered silver layer 25b and the second sintered silver layer 35b, so that the blasting step S04 described above may not be performed.

While the embodiment of the present invention has been described above, the present invention is not limited to this and can be appropriately modified without departing from the technical spirit of the invention.

For example, in the present embodiment, in the laminating step S05, it is described that the thermoelectric conversion element 11 is directly laminated on the first electrode part 25 and the second electrode part 35 and bonded by solid phase diffusion bonding. However, the bonding is not limited thereto. After the silver is applied onto the first electrode part 25 and the second electrode part 35 and dried, the thermoelectric conversion element 11 may be disposed and bonded using the silver paste.

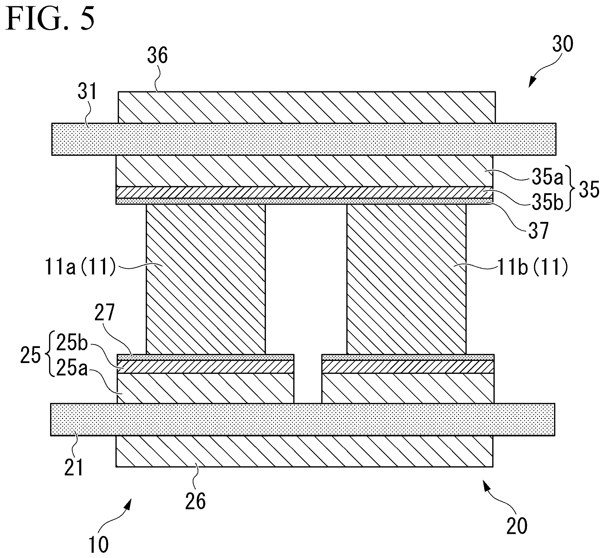

In this case, as illustrated in FIG. 5, a first bonding layer 27 is formed between the first electrode part 25 and the thermoelectric conversion element 11, and a second bonding layer 37 is formed between the second electrode part 35 and the thermoelectric conversion element 11. In the thermoelectric conversion element bonding step S06, Since the pressurizing and heating treatment is performed under the above-described conditions, the porosity of the first bonding layer 27 and the second bonding layer 37 becomes less than 10%.

Furthermore, in the present embodiment, the second insulating circuit board is disposed as the second heat transfer plate 30 on the other end side of the thermoelectric conversion elements 11, but the second heat transfer plate 30 is not limited to this. For example, the second heat transfer plate may be configured by disposing the second electrode part on the other end side of the thermoelectric conversion elements 11, laminating an insulating board, and pressing the insulating board in the laminating direction.

EXAMPLES

A confirmation experiment conducted to confirm the effectiveness of the present invention will be described.

<Example 1>

A thermoelectric conversion module was produced by the same method as in the above-described embodiment.

As a thermoelectric conversion element, a 3 mm $\times$ 3 mm $\times$ 5 mmt half-Heusler element with a Ni base gold electrode was used, and 12 PN pairs were used. As an insulating layer, aluminum nitride having a thickness of 0.635 mm was used. A first aluminum layer and a second aluminum layer were formed by bonding foils having a purity of 99.99 mass% and a thickness of 0.25 mm. The thickness of a first sintered silver layer, and the bonding temperature and bonding load between the thermoelectric conversion element and the first sintered silver layer were set as shown in Table 1.

The bonding atmosphere was set as shown in Table 1, and regarding the bonding between the thermoelectric conversion element and a first electrode part, the thermoelectric conversion element and the first electrode part were directly laminated and bonded. A second sintered silver layer was formed in the same manner as the first sintered silver layer, and a second electrode part was formed in the same manner as the first electrode part.

(Electric Resistance)

By setting the temperature on the first heat transfer plate side of the produced thermoelectric conversion module to 450°C and the temperature on the second heat transfer plate side to 50°C, the electric resistance (internal resistance) was measured (initial resistance).

The temperature difference was continuously given to the thermoelectric conversion module, the rate of increase from the initial value of the internal resistance over time was calculated, and the durability of the thermoelectric conversion module after 24 hours was evaluated (internal resistance increase rate).

As the internal resistance, a variable resistor was installed between output terminals of the thermoelectric conversion module in a state where the temperature difference as described above was given, the current value and the voltage value were measured while changing the resistance, and a graph with the horizontal axis representing the current value and the vertical axis representing the voltage value was created. In this graph, the voltage value when the current value was 0 was taken as an open circuit voltage, and the current value when the voltage value was 0 was taken as a maximum current. In this graph, the open circuit voltage and the maximum current were connected by a straight line, the slope of the straight line was taken as the internal resistance of the entire thermoelectric conversion module, and a value obtained by dividing the value of the internal resistance by the number of PN pairs was taken as the internal resistance. The evaluation results are shown in Table 1.

(Porosity and Thickness of First Sintered Silver Layer)

After mechanically polishing the cross section of the first sintered silver layer of each obtained thermoelectric conversion module, Ar ion etching (Cross Section Polisher SM-09010 manufactured by JEOL Ltd.) was performed thereon, and the cross section was observed using a laser microscope (VK X-200 manufactured by Keyence Corporation). The obtained image was binarized, white parts were determined as Ag, and black parts were determined as pores. From the binarized image, the area of the black parts was obtained, and the porosity was calculated by the following formula. Measurement was performed at five cross sections, and the porosities of the cross sections were arithmetically averaged to obtain the porosity of the first sintered silver layer. A case where the porosity was 10% or more was evaluated as "B", and a case where the porosity was less than 10% was evaluated as "A".

$$\text{Porosity P (\%)} = \text{area of black parts (pore) / observation area of the first sintered silver layer} \times 100$$

The thickness of the first sintered silver layer was measured using the laser microscope. The measurement results are shown in Table 1.

[Table 1]

| | Blasting on first sintered silver layer | Thermoelectric conversion element bonding conditions | | | Sintered silver layer | | Internal resistance | |
|---|---|---|---|---|---|---|---|---|
| | | Bonding atmosphere | Pressurization load (MPa) | Heating temperature (°C) | Thickness ($\mu$m) | Porosity (%) | Initial (m$\Omega$/pair) | Increase rate after durability test (%) |
| Present Invention Example 1 | Present | Vacuum | 30 | 350 | 10 | A | 21 | 0.3 |
| Present Invention Example 2 | Present | Vacuum | 50 | 300 | 5 | A | 22 | 0.4 |
| Present Invention Example 3 | Present | Vacuum | 20 | 400 | 5 | A | 21 | 0.3 |
| Comparative Example 1 | Present | Vacuum | 30 | 350 | 4 | - | - | - |
| Comparative Example 2 | Present | Vacuum | 40 | 250 | 5 | B | 23 | 2.7 |
| Comparative Example 3 | Present | Air | 9 | 450 | 10 | B | 46 | - |
| Comparative Example 4 | Present | Vacuum | 20 | 450 | 5 | - | - | - |
| Comparative Example 5 | Present | Vacuum | 60 | 350 | 10 | - | - | - |

In Comparative Example 1 in which the first sintered silver layer was formed so that the thickness of the first sintered silver layer was less than 5 μm, the first sintered silver layer and the thermoelectric conversion element could not be bonded. It is considered that this is because the first sintered silver layer had been buried in the first aluminum layer.

In Comparative Example 2 in which the heating temperature was low, the porosity exceeded 10%, so that the internal resistance increase rate was high.

In Comparative Example 3 in which the pressurization load was less than 20 MPa, the porosity was high and the initial resistance was high. Therefore, the internal resistance increase rate was not measured.

In Comparative Example 4 in which the bonding temperature exceeded 400°C, the first aluminum layer was crushed. Therefore, in Comparative Example 4, the porosity and electric resistance were not evaluated.

In Comparative Example 5 in which the bonding load exceeded 50 MPa, breaking had occurred in the first insulating layer. Therefore, in Comparative Example 5, the porosity and electric resistance were not evaluated.

On the other hand, in Examples 1 to 3 of the present invention, it was found that the thermoelectric conversion module in which the first sintered silver layer had a thickness of 5 μm or more and a porosity of less than 10%, and the internal resistance increase rate was low could be obtained.

<Example 2>

In the same manner as in Example 1, the thickness of a first sintered silver layer was changed as shown in Table 2, and the presence or absence of a blasting treatment was changed to produce various thermoelectric conversion modules. As for the bonding conditions of a thermoelectric conversion element, the bonding atmosphere was a vacuum, the pressurization load was 30 MPa, and the heating temperature was 350°C.

In the same method as in Example 1, the porosity of the first sintered silver layer was measured.

In addition, a thermal cycle was applied to the obtained thermoelectric conversion modules under the following conditions.

In the thermal cycle, in the atmosphere, 50 cycles of 150°C × 5 minutes and 450°C × 5 minutes were applied to the high temperature side, and the low temperature side was fixed at 80°C. In the same method as in Example 1, the initial internal resistance and the internal resistance increase rate after applying the thermal cycle were obtained. The evaluation results are shown in Table 2. Regarding the internal resistance increase rate after applying the thermal cycle, a case where the increase rate was less than 1% was evaluated as "A" and a case where the increase rate was 1 % or more was evaluated as "B".

[Table 2]

|  | Blasting on first sintered silver layer | Sintered silver layer | | Internal resistance | |
|---|---|---|---|---|---|
|  |  | Thickness (μm) | Porosity | Initial (mΩ/pair) | Increase rate after durability test (%) |
| Present Invention Example 1 | Present | 10 | A | 21 | B |
| Present Invention Example 11 | Absent | 10 | A | 30 | A |
| Present Invention Example 12 | Absent | 20 | A | 26 | A |
| Present Invention Example 13 | Absent | 50 | A | 25 | A |
| Present Invention Example 14 | Absent | 100 | A | 24 | A |

In a case where the thermal cycle was applied to the thermoelectric conversion module of Present Invention Example 1, the internal resistance increase rate after the thermal cycle exceeded 1%. This means that the thermoelectric conversion module in which the first sintered silver layer was subjected to the blasting treatment could keep the rate of increase in internal resistance low in a case of being used at a predetermined temperature or lower, but increased in the internal resistance in a case of being used in an environment in which a high temperature and a low temperature were repeated.

On the other hand, in the thermoelectric conversion modules of Present Invention Examples 11 to 14 in which the first sintered silver layer was not subjected to the blasting treatment, the rate of increase in internal resistance could be kept low even when the thermal cycle was applied. This means that the thermoelectric conversion module in which the first sintered silver layer was not subjected to the blasting treatment was useful in an environment in which a high temperature and a low temperature were repeated.

Moreover, it was confirmed that by setting the thickness of the sintered silver layer to be in a range of 20 $\mu$m or more and 100 $\mu$m or less, the initial internal resistance could be lowered, and the rate of increase in the internal resistance after the thermal cycle could be kept low.

Industrial Applicability

According to the present invention, it is possible to provide a thermoelectric conversion module in which the electric resistance in an electrode part is low, deterioration of a thermoelectric conversion element at the time of bonding is suppressed, and excellent thermoelectric conversion efficiency is achieved, and a method for producing a thermoelectric conversion module.

Reference Signs List

| | |
|---|---|
| 10 | thermoelectric conversion module |
| 11 | thermoelectric conversion element |
| 20 | first heat transfer plate (first insulating circuit board) |
| 21 | first insulating layer |
| 25 | first electrode part |
| 25a | first aluminum layer |
| 25b | first sintered silver layer |
| 30 | second heat transfer plate (second insulating circuit board) |
| 31 | second insulating layer |
| 35 | second electrode part |
| 35a | second aluminum layer |
| 35b | second sintered silver layer |

**Claims**

1. A thermoelectric conversion module comprising:

   a thermoelectric conversion elements;
   a first electrode part disposed on an one end side of the thermoelectric conversion elements; and
   a second electrode part disposed on an other end side of the thermoelectric conversion elements,
   wherein the thermoelectric conversion elements are electrically connected to each other via the first electrode part and the second electrode part,
   a first insulating circuit board provided with a first insulating layer and the first electrode part formed on one surface of the first insulating layer is disposed on the one end side of the thermoelectric conversion elements,
   the first electrode part includes a first aluminum layer made of aluminum or an aluminum alloy, and a first sintered silver layer which is formed on a surface of the first aluminum layer on a side opposite to the first insulating layer and is formed of a sintered body of silver,
   the first aluminum layer has a thickness in a range of 50 $\mu$m or more and 2000 $\mu$m or less, and
   the first sintered silver layer has a thickness of 5 $\mu$m or more and a porosity of less than 10% at least in a region where the thermoelectric conversion element is disposed.

2. The thermoelectric conversion module according to claim 1,
   wherein the thickness of the first sintered silver layer is 20 $\mu$m or more.

3. The thermoelectric conversion module according to claim 1 or 2,
   wherein a second insulating circuit board provided with a second insulating layer and the second electrode part formed on one surface of the second insulating layer is disposed on the other end side of the thermoelectric conversion elements,
   the second electrode part includes a second aluminum layer made of aluminum or an aluminum alloy, and a second sintered silver layer which is formed on a surface of the second aluminum layer on a side opposite to the second insulating layer and is formed of a sintered body of silver,

the second aluminum layer has a thickness in a range of 50 $\mu$m or more and 2000 $\mu$m or less, and

the second sintered silver layer has a thickness of 5 $\mu$m or more and a porosity of less than 10% at least in a region where the thermoelectric conversion element is disposed.

4. The thermoelectric conversion module according to claim 3,
   wherein the thickness of the second sintered silver layer is 20 $\mu$m or more.

5. A method for producing a thermoelectric conversion module, the thermoelectric conversion module including: a thermoelectric conversion elements; a first electrode part disposed on one end side of the thermoelectric conversion elements: and a second electrode part disposed on the other end side of the thermoelectric conversion elements, the thermoelectric conversion elements being electrically connected to each other via the first electrode part and the second electrode part, a first insulating circuit board being provided to the thermoelectric conversion module the first insulating circuit board including a first insulating layer and the first electrode part formed on one surface of the first insulating layer disposed on the one end side of the thermoelectric conversion elements, and the first electrode part including a first aluminum layer made of aluminum or an aluminum alloy, and a first sintered silver layer which is laminated on a surface of the first aluminum layer on a side opposite to the first insulating layer and is formed of a sintered body of silver, the method comprising:

   a silver paste applying step of applying a silver paste containing silver to one surface side of the first aluminum layer to a thickness of more than 5 $\mu$m;
   a sintering step of forming the first electrode part having the first aluminum layer and the first sintered silver layer by sintering the silver paste;
   a laminating step of laminating the first insulating layer on the one end side of the thermoelectric conversion elements via the first electrode part; and
   a thermoelectric conversion element bonding step of bonding the thermoelectric conversion elements by pressurizing and heating the thermoelectric conversion elements and the first insulating layer in a lamination direction, wherein
   a glass-containing silver paste is applied to at least a lowermost layer in contact with the first aluminum layer in the silver paste applying step,
   a pressurization load is in a range of 20 MPa or more and 50 MPa or less and a heating temperature is 300°C or higher and 400°C or lower in the thermoelectric conversion element bonding step, and
   the first sintered silver layer has a thickness of 5 $\mu$m or more and a porosity of less than 10% at least in a region where the thermoelectric conversion element is disposed.

6. The method for producing a thermoelectric conversion module according to claim 5, further comprising:
   a blasting step of performing a blasting treatment on the first sintered silver layer after the sintering step.

7. The method for producing a thermoelectric conversion module according to claim 5 or 6,
   wherein the thermoelectric conversion element is disposed after applying a silver paste onto the first electrode part and drying the silver paste in the laminating step.

8. The method for producing a thermoelectric conversion module according to any one of claims 5 to 7,
   wherein, in the thermoelectric conversion module, a second insulating circuit board provided with a second insulating layer and the second electrode part formed on one surface of the second insulating layer is disposed on the other end side of the thermoelectric conversion elements, and the second electrode part includes a second aluminum layer made of aluminum or an aluminum alloy, and a second sintered silver layer which is laminated on a surface of the second aluminum layer on a side opposite to the second insulating layer and is formed of a sintered body of silver,
   a silver paste containing silver is applied to one surfaces of the first aluminum layer and the second aluminum layer to a thickness of 5 $\mu$m or more, and a glass-containing silver paste is applied to at least lowermost layers in contact with the first aluminum layer and the second aluminum layer in the silver paste applying step,
   the first electrode part including the first aluminum layer and the first sintered silver layer, and the second electrode part including the second aluminum layer and the second sintered silver layer are formed by sintering the silver paste in the sintering step,
   the first insulating layer is laminated on the one end side of the thermoelectric conversion elements via the first electrode part, and the second insulating layer is laminated on the other end side of the thermoelectric conversion elements via the second electrode part in the laminating step,

the first electrode part and the thermoelectric conversion element, and the thermoelectric conversion element and the second electrode part are bonded by pressurizing and heating the first insulating layer, the thermoelectric conversion element, and the second insulating layer in the lamination direction in the thermoelectric conversion element bonding step, and

the pressurization load is in the range of 20 MPa or more and 50 MPa or less, the heating temperature is 300°C or higher and 400°C or lower, and the first sintered silver layer and the second sintered silver layer have a thickness of 5 μm or more and a porosity of less than 10% at least in regions where the thermoelectric conversion element is disposed in the thermoelectric conversion element bonding step.

9. The method for producing a thermoelectric conversion module according to claim 8, further comprising:
a blasting step of performing a blasting treatment on the first sintered silver layer and the second sintered silver layer after the sintering step.

10. The method for producing a thermoelectric conversion module according to claim 8 or 9,
wherein the thermoelectric conversion element is disposed after applying a silver paste onto the second electrode part and drying the silver paste in the laminating step.

FIG. 1

# FIG. 2

```
┌─────────────────────────────────┐
│   ALUMINUM LAYER FORMING STEP    │～S01
└─────────────────────────────────┘
                 │
                 ▼
┌─────────────────────────────────┐
│     SILVER PASTE APPLYING STEP    │～S02
└─────────────────────────────────┘
                 │
                 ▼
┌─────────────────────────────────┐
│          SINTERING STEP          │～S03
└─────────────────────────────────┘
         │                │
         ▼                │
┌───────────────┐         │
S04～│ BLASTING STEP │      │
└───────────────┘         │
         │                │
         ▼                ▼
┌─────────────────────────────────┐
│          LAMINATING STEP         │～S05
└─────────────────────────────────┘
                 │
                 ▼
┌─────────────────────────────────┐
│    THERMOELECTRIC CONVERSION     │～S06
│      ELEMENT BONDING STEP        │
└─────────────────────────────────┘
                 │
                 ▼
(   THERMOELECTRIC CONVERSION MODULE   )
```

FIG. 3

FIG. 4

FIG. 5

# INTERNATIONAL SEARCH REPORT

| | International application No. |
|---|---|
| | PCT/JP2018/024828 |

## A. CLASSIFICATION OF SUBJECT MATTER

Int.Cl. H01L35/32(2006.01)i, H01L35/08(2006.01)i, H01L35/34(2006.01)i, H02N11/00(2006.01)i

According to International Patent Classification (IPC) or to both national classification and IPC

## B. FIELDS SEARCHED

Minimum documentation searched (classification system followed by classification symbols)
Int.Cl. H01L35/32, H01L35/08, H01L35/34, H02N11/00

| Documentation searched other than minimum documentation to the extent that such documents are included in the fields searched | |
|---|---|
| Published examined utility model applications of Japan | 1922–1996 |
| Published unexamined utility model applications of Japan | 1971–2018 |
| Registered utility model specifications of Japan | 1996–2018 |
| Published registered utility model applications of Japan | 1994–2018 |

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
|---|---|---|
| X<br>Y | JP 2017-59823 A (MITSUBISHI MATERIALS CORP.) 23 March 2017, paragraphs [0030]-[0032], [0036], [0038], [0051], [0058], fig. 1-9 & WO 2017/047627 A1, paragraphs [0031]-[0033], [0037], [0039], [0052], [0059], fig. 1-9 | 1-5,7,8,10<br>1-10 |
| Y | JP 2013-197265 A (TOTO LTD.) 30 September 2013, paragraph [0006], fig. 1 (Family: none) | 1-10 |
| Y | JP 2014-236106 A (YAMAHA CORP.) 15 December 2014, paragraphs [0028], [0032], fig. 1-2 (Family: none) | 6,9 |

☒ Further documents are listed in the continuation of Box C.     ☐ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 06 September 2018 (06.09.2018) | 18 September 2018 (18.09.2018) |

| Name and mailing address of the ISA/<br>Japan Patent Office<br>3-4-3, Kasumigaseki, Chiyoda-ku,<br>Tokyo 100-8915, Japan | Authorized officer<br><br>Telephone No. |
|---|---|

Form PCT/ISA/210 (second sheet) (January 2015)

**INTERNATIONAL SEARCH REPORT**

International application No.

PCT/JP2018/024828

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2017-69555 A (MITSUBISHI MATERIALS CORP.) 06 April 2017, paragraphs [0025]-[0056], fig. 1-8 & WO 2017/057259 A1, paragraphs [0027]-[0058], fig. 1-8 | 1-10 |
| A | JP 7-321378 A (MATSUSHITA ELECTRIC INDUSTRIAL CO., LTD.) 08 December 1995, paragraphs [0043]-[0057], fig. 1-5 (Family: none) | 1-10 |

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2017132050 A
- JP 2018118764 A
- JP 2013197265 A
- JP 2012231025 A